# EUROPÄISCHE PATENTSCHRIFT

(11) **EP 3 600 939 B1**
(45) Veröffentlichungstag und Bekanntmachung des Hinweises auf die Patenterteilung: **20.04.2022**
(21) Anmeldenummer: 18713204.8
(22) Anmeldetag: 22.03.2018
(51) Int. Cl.: B60K 37/06, B60K 35/00, G06F 3/0482, G06F 3/044, H03K 17/96

(54) **FAHRZEUG MIT SMART TOUCH**
VEHICLE WITH SMART TOUCH
VÉHICULE À CONTACT TACTILE INTELLIGENT

(30) Priorität: 22.03.2017 DE 102017106212
(43) Veröffentlichungstag der Anmeldung: 05.02.2020
(73) Patentinhaber: FM Marketing GmbH, 5202 Neumarkt am Wallersee (AT)
(72) Erfinder: MAIER, Ferdinand, 5202 Neumarkt am Wallersee (AT)
(74) Vertreter: von Bülow & Tamada
(86) Internationale Anmeldenummer: PCT/EP2018/057291
(87) Internationale Veröffentlichungsnummer: WO 2018/172456

(56) Entgegenhaltungen:
- EP-A2- 2 610 706
- EP-A2- 2 952 376
- WO-A1-2018/046389
- US-A1- 2005 024 342

## Beschreibung

Die vorliegende Erfindung betrifft ein Fahrzeug und ein Verfahren zur Steuerung eines Menüs auf einer Wiedergabeeinrichtung in dem Fahrzeug.

Aus der US 2014/0172186 A1 ist ein Fahrzeug bekannt, in dem an einem Lenkrad verschiedene Tasten angeordnet sind, mit denen sich im Fahrzeug verschiedene Funktionen aktivieren lassen. Der Fahrer kann sich die Funktion durch Berühren der Tasten in einem Head-Up-Display anzeigen lassen und durch Drücken der Tasten ausführen. Eine visuelle Interaktion mit den Tasten ist nicht notwendig.

Aus der EP 2 952 376 A2 und der US 2005 / 024 342 A1 ist ein Fahrzeug gemäß dem Oberbegriff des Anspruchs 1 bekannt.

Es ist Aufgabe der Erfindung, die Bedienung zu verbessern.

Gemäß einem Aspekt der Erfindung umfasst ein Fahrzeug ein auf Rädern in einer Fahrtrichtung fahrbar getragenes Fahrgestell zum Tragen eines Fahrers, ein Lenkelement zum Vorgeben der Fahrtrichtung durch den Fahrer, ein in Fahrtrichtung gesehen vor dem Fahrer in seinem Blickfeld angeordnetes Wiedergabeelement, das eingerichtet ist, ein Menü mit einer Anzahl zu einem Raster angeordneten Menüelementen anzuzeigen und eine Eingabeschnittstelle mit einer am Lenkelement angeordneten Druckplatte, die eine Oberseite und eine der Oberseite gegenüberliegende Unterseite umfasst, wobei auf der Oberseite der Druckplatte eine Anzahl zu dem Raster angeordneten haptisch erfassbaren Segmenten ausgebildet ist und wobei die Anzahl der Menüelemente der Anzahl der haptisch erfassbaren Segmente entspricht, so dass jedem Menüelement des Menüs ein haptisch erfassbares Segment auf der Druckplatte zugeordnet ist.

Dem angegebenen Fahrzeug liegt die Überlegung zugrunde, dass eine Menüführung beispielsweise auf Smartphones für den Fahrer visuell sehr interaktionsintensiv ist. Der Fahrer muss ständig nachsehen, welchen Menüpunkt er auswählen möchte, bevor er auf dem Menüpunkt die eigentliche Auswahl durchführt. Dies macht eine Menüführung während der Fahrt mit einem Fahrzeug äußerst risikoreich und für jeden vernünftig am Straßenverkehr teilnehmenden Fahrer nahezu unmöglich.

Hier greift das angegebene Fahrzeug mit dem Gedanken an, dem Fahrer das Menü während der Menüführung in einen Sichtbereich zu projektieren, in dem er gleichzeitig den laufenden Verkehr im Auge behalten kann. Dies kann beispielsweise auf einem Navigationsgerät, auf einem Armaturenbrett oder auf einem Head-Up-Display sein. Das zu steuernde Menü und das Eingabeelement, über welches das Menü gesteuert wird, sind dabei derart verknüpft, dass sich der Fahrer durch haptisches Erfühlen einerseits und durch intuitives Handeln andererseits im Menü zurechtfindet. Der Fahrer kann so das Menü im Sichtbereich des Straßenverkehrs nachvollziehen und steuern, ohne auf seine Hände bei der Menüführung sehen zu müssen. Der Fahrer wird dadurch nicht mehr abgelenkt, was deutlich zur Verkehrssicherheit beiträgt. Bei mehr als 50.000 geschätzten Verkehrsunfällen durch Smartphones allein auf deutschen Straßen ist der Sicherheitsgewinn durch das angegebene Fahrzeug klar erkennbar.

Das Fahrzeug kann beliebig ausgeführt sein, beispielsweise als Personenkraftwagen, als Motorrad, als Fahrrad, als Lastkraftwagen oder in sonst einer Weise.

In einer Weiterbildung des angegebenen Fahrzeuges umfasst das Lenkelement einen Griffbereich, wobei die Druckplatte in einem Bereich am Lenkelement angeordnet ist, der mit einem Daumen des Fahrers erreichbar ist, wenn er das Griffelement mit seinen restlichen Fingern umfasst. Auf diese Weise kann der Fahrer das Menü bedienen, ohne seine Hände vom Steuer nehmen zu müssen.

Erfindungsgemäß sind die haptisch erfassbaren Segmente in die Oberseite der Druckplatte eingelassene Mulden. Gegenüber konvexen Tasten haben Mulden den Vorteil, dass diese eine höhere Kontaktfläche mit dem Finger des Fahrers bieten und so durch den Fahrer deutlich besser haptisch erfassbar sind.

Erfindungsgemäß sind die Mulden dabei im Wesentlichen kugelsegmentförmig ausgebildet, was die größte haptische Kontaktfläche zwischen dem Finger des Fahrers und dem haptisch erfassbaren Segment bietet.

In einer noch anderen Weiterbildung des angegebenen Fahrzeuges ist das Raster ein kartesisches Gitter, wie es beispielsweise auf gängigen Smartphones zu finden ist.

In einer weiteren Weiterbildung umfasst das angegebene Fahrzeug einen an der Unterseite der Druckplatte angeordneten Sensor, der eingerichtet ist, an das Wiedergabeelement ein Tastenauswahlsignal in Abhängigkeit der Lage des Fingers auf der Oberseite der Druckplatte auszugeben. Auf diese Weise lässt sich die Lage des Fingers am kostengünstigsten und ausfallsichersten erfassen.

In einer zusätzlichen Weiterbildung des angegebenen Fahrzeuges ist die Druckplatte in einer Richtung vertikal zur Oberseite und Unterseite beweglich gelagert, wobei an der Unterseite der Druckplatte eine Drucktaste angeordnet ist, mit deren Druck ein Tastenbestätigungssignal erzeugbar ist. Auf diese Weise lässt sich der Auslösevorgang eines Menüelementes mit einer einzigen Taste realisieren, wodurch sich die Eingabeschnittstelle in dem angegebenen Fahrzeug besonders kompakt und bauraumsparend ausführen lässt.

Gemäß einem weiteren Aspekt der Erfindung umfasst ein Verfahren zum Steuern eines Menüs auf einem Wiedergabeelement eines der angegebenen Fahrzeuge die Schritte: Empfangen eines Positionssignals, das von der Position eines Fingers des Fahrers auf der Druckplatte abhängig ist, Hervorheben des Menüelementes, das dem haptisch erfassbaren Segment zugeordnet ist, welches sich an der Position des Fingers befindet und Auslösen einer dem hervorgehobenen Menüelement zugeordneten Funktion, wenn die Druckplatte betätigt wird.

Gemäß einem weiteren Aspekt der Erfindung ist eine Steuervorrichtung eingerichtet, eines der angegebenen Verfahren durchzuführen.

In einer Weiterbildung der angegebenen Vorrichtung weist die angegebene Vorrichtung einen Speicher und einen Prozessor auf. Dabei ist das angegebene Verfahren in Form eines Computerprogramms in dem Speicher hinterlegt und der Prozessor zur Ausführung des Verfahrens vorgesehen, wenn das Computerprogramm aus dem Speicher in den Prozessor geladen ist.

Gemäß einem weiteren Aspekt der Erfindung umfasst ein Computerprogramm Programmcodemittel, um alle Schritte des angegebenen Verfahrens durchzuführen, wenn das Computerprogramm auf einem Computer oder einer der angegebenen Vorrichtungen ausgeführt wird.

Gemäß einem weiteren Aspekt der Erfindung enthält ein Computerprogrammprodukt einen Programmcode, der auf einem computerlesbaren Datenträger gespeichert ist und der, wenn er auf einer Datenverarbeitungseinrichtung ausgeführt wird, das angegebene Verfahren durchführt.

Die oben beschriebenen Eigenschaften, Merkmale und Vorteile dieser Erfindung sowie die Art und Weise wie diese erreicht werden, werden verständlicher im Zusammenhang mit der folgenden Beschreibung der Ausführungsbeispiele, die im Zusammenhang mit der Zeichnung näher erläutert werden. Es zeigen:
Fig. 1 eine schematische Darstellung eines Fahrzeuges;
Fig. 2 eine schematische Darstellung eines Cockpits in dem Fahrzeug der Fig. 1;
Fig. 3 eine schematische Darstellung einer Eingabeschnittstelle, die an einen Bildschirm in dem Cockpit der Fig. 2 angeschlossen ist, in einem ersten Zustand;
Fig. 4 eine schematische Darstellung einer Eingabeschnittstelle, die an einen Bildschirm in dem Cockpit der Fig. 2 angeschlossen ist, in einem zweiten Zustand; und
Fig. 5 eine schematische Darstellung einer Eingabeschnittstelle, die an einen Bildschirm in dem Cockpit der Fig. 2 angeschlossen ist, in einem dritten Zustand.

In den Figuren werden gleiche technische Elemente mit gleichen Bezugszeichen versehen und nur einmal beschrieben. Die Figuren sind rein schematisch und geben vor allem nicht die tatsächlichen geometrischen Verhältnisse wieder.

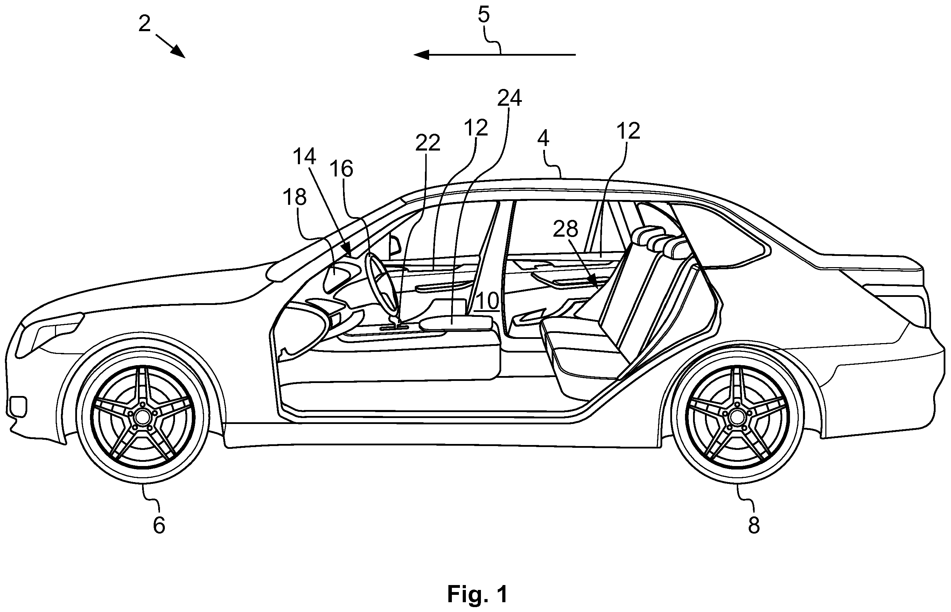

Es wird auf Fig. 1 Bezug genommen, die eine Seitenansicht eines teilweise dargestellten Fahrzeuges 2 zeigt. Das Fahrzeug 2 umfasst ein Fahrgestell in Form eines Chassis 4, das in einer Fahrtrichtung 5 fahrbar auf Rädern 6, 8 getragen ist. Von diesen Rädern 6, 8 ist in Fig. 1 ein Vorderrad 6 und ein Hinterrad 8 zu sehen.

Das Chassis 4 begrenzt einen Fahrgastraum 10, der durch Türen 12 geöffnet und verschlossen werden kann. Um in den Fahrgastraum 10 sehen zu können, sind in Fig. 1 die Türen 12 nicht dargestellt, die zum Betrachter hin gerichtet am Fahrzeug 2 vorhanden sind.

Im Fahrgastraum 10 befindet sich ein Cockpit 14, in dem als Lenkelement ein Lenkrad 16 zum Einschlagen der Vorderräder 6 für eine Änderung der Fahrtrichtung 5 sowie ein Armaturenbrett 18 zum Anzeigen verschiedener relevanter Informationen zum Zustand des Fahrzeuges 2, beispielsweise seiner Geschwindigkeit an einen Fahrer des Fahrzeuges angeordnet sind. Unterhalb des Cockpits 14 befindet sich ein nicht weiter dargestelltes Gaspedal zum Beschleunigen des Fahrzeuges 2, ein nicht gezeigtes Bremspedal zum Abbremsen des Fahrzeuges 2, und ein Gangwahlhebel 22 zum Einlegen eines Ganges in einem nicht weiter zu sehenden Getriebe des Fahrzeuges 2.

Nicht dargestellt sind in Fig. 1 neben den zum Betrachter hin gerichteten Türen 12 auch ein Sitz für den Fahrer und ein Sitz für einen Beifahrer, die beide durch eine gezeigte Mittelkonsole 24 voneinander getrennt sind. Ferner befindet in Fahrtrichtung 5 betrachtet sich hinter dem Fahrersitz und dem Beifahrersitz eine Rückbank 28.

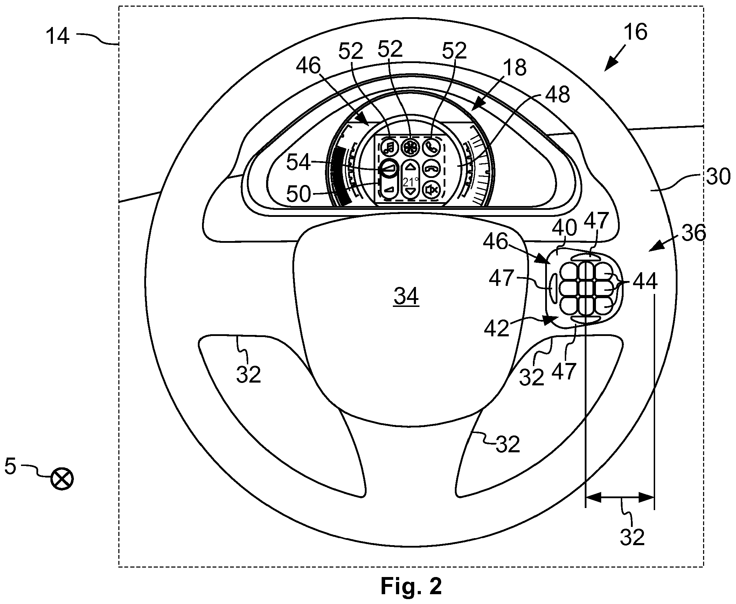

Es wird auf Fig. 2 Bezug genommen, die in Fahrtrichtung 5 betrachtet eine beispielhafte Ausführung des Cockpits 14 von hinten zeigt.

Das Lenkrad 16 umfasst einen Griffbereich 30, an dem der Fahrer das Lenkrad 16 greifen und zum Einschlagen der Vorderräder 6 drehen kann. Radial innerhalb des Griffbereichs befindet sich ein Airbag-Gehäuse 34, in dem ein nicht weiter zu sehender Airbag zum Aufprallschutz des Fahrers angeordnet ist. Eine derartige Aufprallschutzfunktion ist bestens bekannt, weshalb auf eine nähere Erläuterung nachstehend verzichtet werden soll.

Das Airbag-Gehäuse 34 ist fest mit einer nicht gezeigten Lenksäule verbunden. Auf diese Weise kann ein in den Griffbereich 30 eingetragenes Drehmoment des Fahrers auf die Lenksäule zu übertragen werden, um die Lenksäule zu drehen. In einer an sich bekannten Weise führt die Drehung der Lenksäule dann zum Einschlag der Vorderräder 6, worauf allerdings ebenfalls nicht weiter eingegangen werden soll.

Auf einer der Streben 32 zwischen dem Griffbereich 30 und dem Airbag-Gehäuse 34 ist eine Eingabeschnittstelle 36 angeordnet. Die Eingabeschnittstelle 36 liegt auf der Strebe 32 vom Griffbereich 30 mit einem Abstand 38 derart entfernt, dass der Fahrer, der den Griffbereich 30 mit seiner Hand umgreift, die Eingabeschnittstelle 36 mit seinem Daumen erreichen kann.

Die Eingabeschnittstelle 36 umfasst eine Druckplatte 40, auf deren in Fahrtrichtung 5 gesehenen Oberseite 42 haptisch erfassbare Segmente in Form von Mulden 44 zu einem Raster 46 angeordnet sind. Ferner kann die Eingabeschnittstelle 36 zusätzliche Drucktasten 47 umfassen, die unabhängig von der Druckplatte 40 bedienbar sind.

Der Fahrer kann mit seinem Daumen über die einzelnen Mulden 44 des Rasters 46 fahren und sie so erfühlen. Gleichzeitig wird auf einem Bildschirm 48 im Armaturenbrett 18 ein in Fig. 2 gestrichelt umrandet hervorgehobenes Menü 50 mit Menüelementen 52 dargestellt, die zu dem gleichen Raster 46 angeordnet sind, wie das Raster 46 auf der Druckplatte 40 der Eingabeschnittstelle 36.

Bewegt der Fahrer seinen Daumen über die Druckplatte 40, so sieht er anhand einer Hervorhebung 54 der Menüelemente 52, wo auf der Druckplatte 40 sich sein Daumen befindet. Durch Niederdrücken der Druckplatte 40 an der Mulde 44 eines gewünschten Menüpunktes 52 wählt der Fahrer dann den gewünschten Menüpunkt aus. Durch die haptische Rückmeldung über die Mulden 44 lernt der Fahrer intuitiv mit der Bedienung des Menüs 50 umzugehen und braucht im Idealfall überhaupt keine visuelle Interaktion mit dem Menü 50 mehr. In jedem Fall befindet sich das Menü 50 bei der Bedienung in der Fahrtrichtung 5, so dass der Fahrer bei der Fahrt den Straßenverkehr nicht aus dem Auge zu verlieren braucht.

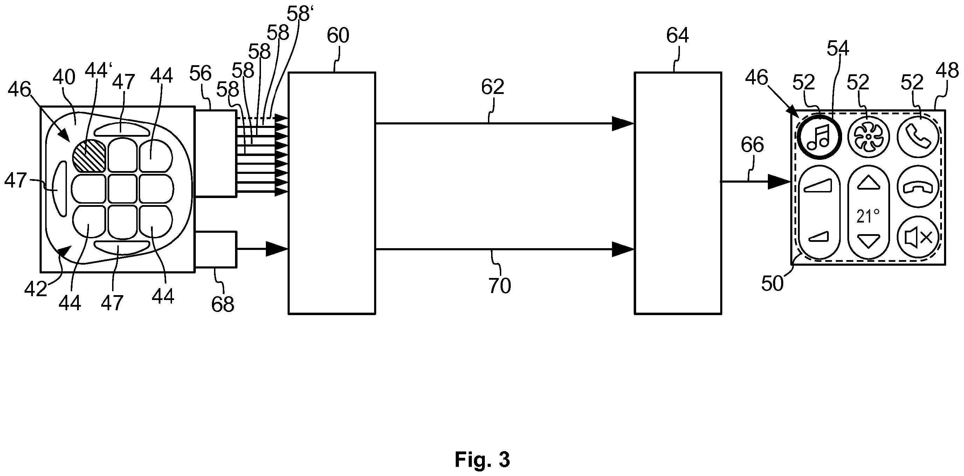

Die Bedienung des Menüs mit der Druckplatte soll nachstehend anhand der Fig. 3 bis 5 näher erläutert werden.

Die Hervorhebung 54 wird durch einen in Fig. 3 bis 5 schematisch angedeuteten kapazitiven Sensor 56 generiert, der auf einer der Oberseite 42 gegenüberliegenden und in den Figuren nicht zu sehenden Unterseite der Druckplatte 40 angeordnet ist. Der kapazitive Sensor 56 umfasst eine Vielzahl von nicht gezeigten Kondensatorplatten, wovon sich unterhalb jeder Mulde 44 an der Unterseite der Druckplatte 40 eine dieser Kondensatorplatten befindet. Zu jeder Kondensatorplatte ist in an sich bekannter eine Auswerteleitung 58 geführt. Von diesen Auswerteleitungen 58 sind in Fig. 3 bis 5 nicht alle mit einem Bezugszeichen versehen. Jede Kondensatorplatte ist von ihrer Auswerteleitung 58 galvanisch getrennt.

In einem Ruhezustand weist jede Kondensatorplatte gegenüber ihrer Auswerteleitung 58 eine Grundkapazität auf. Bewegt der Fahrer seinen Daumen über die Mulde 44, die über der entsprechenden Kondensatorplatte auf der Oberseite der Druckplatte 40 ausgebildet ist, so verändert sich die Kapazität der entsprechenden Kondensatorplatte gegenüber ihrer zugeordneten Auswerteleitung 58. In Fig. 3 ist eine der Mulden mit dem Bezugszeichen 44' versehen und schraffiert ausgemalt, um anzudeuten, dass dort der Benutzer seinen Daumen aufgelegt hat. Unter schraffierten Mulden 44' sollen daher nachstehend der übersichtlicheren Erläuterung halber Mulden 44 verstanden werden, auf die der Fahrer seinen Daumen aufgelegt hat.

Alle Auswerteleitungen 58 sind an eine Auswerte- und Sendeeinrichtung 60 angelegt. Auf jeder Auswerteleitung 58 liegt ein Signal mit einem Signalpegel, der davon abhängig ist, ob der Daumen des Fahrers auf die entsprechende Mulde 44 aufgelegt ist, oder nicht. Auswerteleitungen 58, auf denen ein Signalpegel liegt, der der Grundkapazität ohne auf die entsprechende Mulde 44 aufgelegten Daumen des Fahrers entspricht, sind in Fig. 3 bis 5 mit durchgezogenen Linien dargestellt. Auswerteleitungen, auf denen ein Signalpegel liegt, der einer Kapazität mit auf die entsprechende Mulde 44' aufgelegtem Daumen des Fahrers entspricht, sind in Fig. 3 bis 5 mit gestrichelten Linien dargestellt und der Übersichtlichkeit halber mit dem Bezugszeichen 58' versehen.

Die Auswerte- und Sendeeinrichtung 60 wertet die Signalpegel auf den Auswerteleitungen 58 aus und bestimmt, ob und auf welcher Mulde 44 der Fahrer seinen Finger aufgelegt hat. Aus dieser Information generiert die Auswerte- und Sendeeinrichtung 60 ein Positionssignal 62, das sie über ein Kabel im Fahrzeug 2 an eine Steuereinrichtung 64 sendet. Das Senden kann allerdings auch kabellos erfolgen.

Die Steuereinrichtung 64 erzeugt ein Bildsignal 66. Basierend auf diesem Bildsignal 66 wird das Menü 50 mit seinen Menüpunkten 52 auf dem Bildschirm 48 ausgegeben. Basierend auf dem Positionssignal 62 steuert die Steuereinrichtung 64 den Bildschirm 48 dann derart an, dass der Menüpunkt 52, der im Raster 46 an der gleichen Stelle ist, wie die mit dem Daumen berührte Mulde 44' mit der Hervorhebung 54 hervorgehoben wird. Auf diese Weise kann der Fahrer nachvollziehen, wo auf der Druckplatte 40 sich sein Daumen befindet.

Möchte der Fahrer eine mit dem durch die Hervorhebung 54 hervorgehobenen Menüpunkt 52 verknüpfte Funktion auslösen, dann drückt der Fahrer die Druckplatte 40 mit seinem Daumen in das Lenkrad 16. An der Unterseite der Druckplatte 40 befindet sich neben dem kapazitiven Sensor 56 eine Drucktaste 68, die in Fig. 3 ebenfalls nur schematisch angedeutet ist. Wird die Drucktaste 68 über den Druck der Druckplatte 40 ausgelöst, sendet die Auswerte- und Sendeeinrichtung 60 ein Auslösesignal 70 an die Steuereinrichtung 64, die dann wiederum die Ansteuerung weiterer Elemente im Fahrzeug 2 auslöst, die mit der zuvor genannten verknüpften Funktion verbunden ist. In Fig. 3 ist diese verknüpfte Funktion beispielsweise das Öffnen eines Audiowiedergabeprogramms.

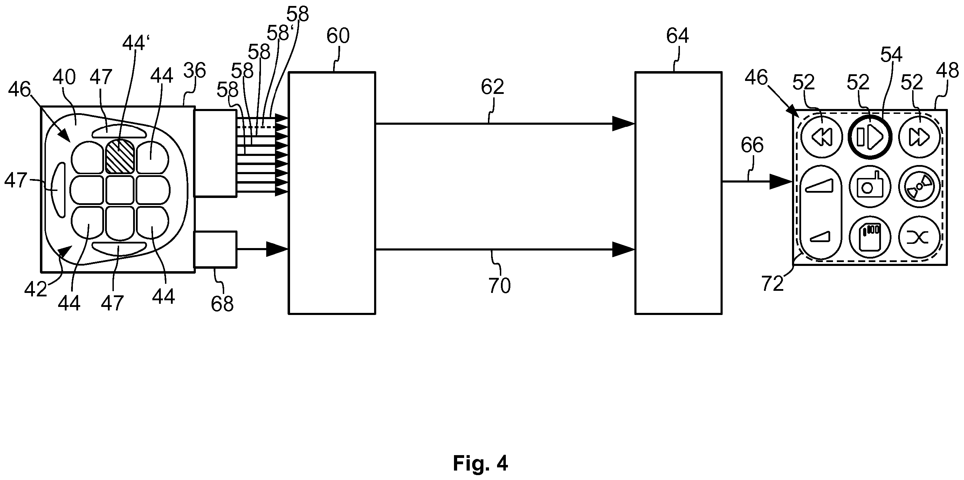

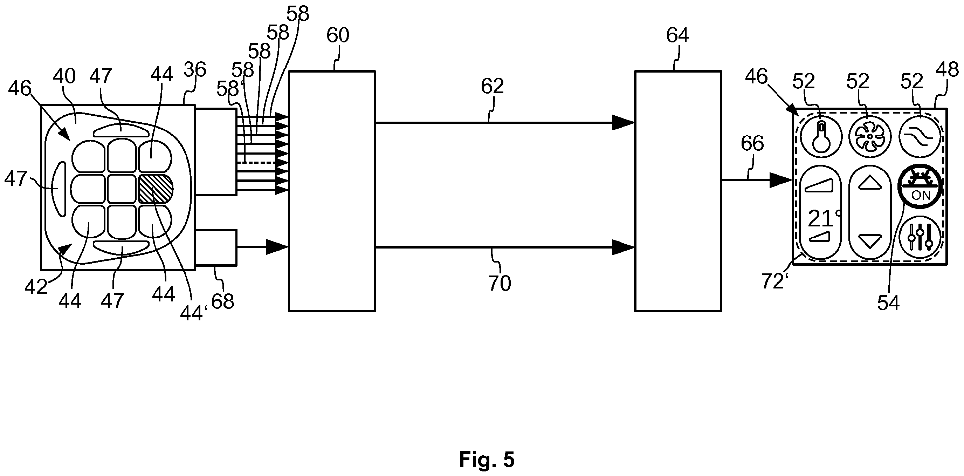

Das entsprechende Untermenü 72 ist in Fig. 4 gezeigt. Hier wählt der Fahrer beispielhaft eine Wiedergabefunktion aus, mit der die Wiedergabe eines Musikstücks gestartet wird. In Fig. 5 ist ein alternatives Untermenü 72' zur Steuerung einer Klimaanlage in dem Fahrzeug 2 dargestellt.

## Patentansprüche

1. Fahrzeug (2) umfassend:
- ein auf Rädern (6, 8) in einer Fahrtrichtung (5) fahrbar getragenes Fahrgestell (4) zum Tragen eines Fahrers,
- ein Lenkelement (16) zum Vorgeben der Fahrtrichtung (6) durch den Fahrer,
- ein in Fahrtrichtung (5) gesehen vor dem Fahrer in seinem Blickfeld angeordnetes Wiedergabeelement (48), das eingerichtet ist, ein Menü (50) mit einer Anzahl zu einem Raster (46) angeordneten Menüelementen (52) anzuzeigen, und
- eine Eingabeschnittstelle (36) mit einer am Lenkelement (16) angeordneten Druckplatte (40), die eine Oberseite (42) und eine der Oberseite (42) gegenüberliegende Unterseite umfasst, wobei auf der Oberseite (42) der Druckplatte (40) eine Anzahl zu dem Raster (46) angeordneten haptisch erfassbaren Segmenten (44) ausgebildet ist, und wobei die Anzahl der Menüelemente (52) der Anzahl der haptisch erfassbaren Segmente (44) entspricht, so dass jedem Menüelement (52) des Menüs (50) ein haptisch erfassbares Segment (44) auf der Druckplatte (40) zugeordnet ist, und
- einen an der Unterseite der Druckplatte (40) angeordneten Sensor (56), der eingerichtet ist, an das Wiedergabeelement (48) ein Tastenauswahlsignal (62) in Abhängigkeit der Lage eines Fingers auf der Oberseite (42) der Druckplatte (40) auszugeben,
**dadurch gekennzeichnet, dass**
- die haptisch erfassbaren Segmente (44) in die Oberseite (42) der Druckplatte (40) eingelassene kugelsegmentförmige Mulden (44) sind, wobei sich unterhalb jeder Mulde (44) an der Unterseite der Druckplatte (40) je eine Kondensatorplatte befindet, die zusammen den Sensor (56) bilden.

2. Fahrzeug (2) nach Anspruch 1, wobei das Lenkelement (16) einen Griffbereich (30) umfasst, und wobei die Druckplatte (40) in einem Bereich (32) am Lenkelement (16) angeordnet ist, der mit einem Daumen des Fahrers erreichbar ist, wenn er das Griffelement (30) mit seinen restlichen Fingern umfasst.

3. Fahrzeug (2) nach einem der vorstehenden Ansprüche, wobei das Raster (46) ein kartesisches Gitter ist.

4. Fahrzeug (2) nach einem der vorstehenden Ansprüche, wobei die Druckplatte (40) in einer Richtung vertikal zur Oberseite (42) und Unterseite beweglich gelagert ist und wobei an der Unterseite der Druckplatte eine Drucktaste (68) angeordnet ist, mit deren Druck ein Tastenbestätigungssignal (70) erzeugbar ist.

5. Verfahren zum Steuern eines auf einem Wiedergabeelement (48) eines Fahrzeuges (2) nach einem der vorstehenden Ansprüche angezeigten Menüs (50), umfassend:
- Empfangen eines Positionssignals (62), das von der Position eines Fingers des Fahrers auf der Druckplatte (40) abhängig ist,
- Hervorheben des Menüelementes (52), das dem haptisch erfassbaren Segment (44) zugeordnet ist, welches sich an der Position des Fingers befindet, und
- Auslösen einer dem hervorgehobenen Menüelement (52) zugeordneten Funktion, wenn die Druckplatte (40) betätigt wird.

6. Steuervorrichtung (60), die eingerichtet ist, ein Verfahren nach Anspruch 5 durchzuführen.

7. Computerprogramm umfassend Programmcodemittel, um alle Schritte eines Verfahrens nach Anspruch 5 durchzuführen, wenn das Computerprogramm auf der Steuervorrichtung nach Anspruch 6 ausgeführt wird.

## Claims

1. Vehicle (2) comprising:
- a chassis (4) supported on wheels (6, 8) so as to be movable in a travel direction (5) for carrying a driver,
- a steering element (16) for presetting the travel direction (6) by the driver,
- a display element (48) arranged in front of the driver in his field of vision as seen in the travel direction (5), which is arranged to display a menu (50) with a number of menu elements (52) arranged in a grid (46), and
- an input interface (36) with a pressure plate (40) arranged on the steering element (16), which pressure plate (40) comprises an upper side (42) and a lower side opposite the upper side (42), wherein a number of haptically detectable segments (44) arranged to the grid (46) are formed on the upper side (42) of the pressure plate (40) and wherein the number of menu elements (52) corresponds to the number of haptically detectable segments (44), so that each menu element (52) of the menu (50) is associated with a haptically detectable segment (44) on the printing plate (40), and
- a sensor (56) arranged on the underside of the printing plate (40), which sensor (56) is arranged to output a key selection signal (62) to the reproduction element (48) as a function of the position of a finger on the upper side (42) of the printing plate (40),
**characterized in that**
- the haptically detectable segments (44) are spherical segment-shaped troughs (44) recessed into the upper side (42) of the pressure plate (40), wherein a capacitor plate is located below each trough (44) on the underside of the pressure plate (40), which together form the sensor (56).

2. Vehicle (2) according to claim 1, wherein the steering element (16) comprises a grip area (30), and wherein the pressure plate (40) is arranged in an area (32) on the steering element (16) that can be reached with a thumb of the driver when he grips the grip element (30) with his remaining fingers.

3. Vehicle (2) according to any of the preceding claims, wherein the grid (46) is a Cartesian grid.

4. Vehicle (2) according to one of the preceding claims, wherein the pressure plate (40) is mounted movably in a direction vertical to the upper side (42) and lower side, and wherein a push button (68) is arranged on the lower side of the pressure plate, with the pressure of which a button confirmation signal (70) can be generated.

5. Method for controlling a menu (50) displayed on a display element (48) of a vehicle (2) according to one of the preceding claims, comprising:
- Receiving a position signal (62) dependent on the position of a finger of the driver on the pressure plate (40),
- highlighting the menu item (52) associated with the haptically detectable segment (44) located at the position of the finger, and
- triggering a function associated with the highlighted menu item (52) when the pressure plate (40) is actuated.

6. Control device (60) adapted to perform a method according to claim 5.

7. Computer program comprising program code means to perform all steps of a method according to claim 5 when the computer program is executed on the control device according to claim 6. '

## Revendications

1. Véhicule (2) comprenant :
- un châssis (4) supporté de manière mobile sur des roues (6, 8) dans une direction de déplacement (5) pour supporter un conducteur,
- un élément de direction (16) pour indiquer la direction de déplacement (6) au conducteur,
- un élément d'affichage (48) disposé devant le conducteur dans son champ de vision, vu dans le sens de la marche (5), qui est conçu pour afficher un menu (50) avec un certain nombre d'éléments de menu (52) disposés en une trame (46), et
- une interface d'entrée (36) avec une plaque de pression (40) disposée sur l'élément de direction (16), qui comprend une face supérieure (42) et une face inférieure opposée à la face supérieure (42), un certain nombre de segments (44) haptiquement détectables, disposés par rapport à la trame (46), étant réalisés sur la face supérieure (42) de la plaque de pression (40), et le nombre des éléments de menu (52) correspondant au nombre des segments (44) détectables haptiquement, de sorte qu'à chaque élément de menu (52) du menu (50) est associé un segment (44) détectable haptiquement sur la plaque d'impression (40), et
- un capteur (56) disposé sur la face inférieure de la plaque d'impression (40), qui est conçu pour délivrer à l'élément de reproduction (48) un signal de sélection de touche (62) en fonction de la position d'un doigt sur la face supérieure (42) de la plaque d'impression (40),
**caractérisé en ce que**
- les segments (44) détectables haptiquement sont des creux (44) en forme de segments de sphère encastrés dans la face supérieure (42) de la plaque d'impression (40), une plaque de condensateur se trouvant sous chaque creux (44) sur la face inférieure de la plaque d'impression (40), qui forment ensemble le capteur (56).

2. Véhicule (2) selon la revendication 1, dans lequel l'élément de direction (16) comprend une zone de préhension (30), et dans lequel la plaque de pression (40) est disposée dans une zone (32) sur l'élément de direction (16) qui peut être atteinte avec un pouce du conducteur lorsqu'il entoure l'élément de préhension (30) avec ses autres doigts.

3. Véhicule (2) selon l'une quelconque des revendications précédentes, dans lequel la grille (46) est une grille cartésienne.

4. Véhicule (2) selon l'une des revendications précédentes, dans lequel la plaque de pression (40) est montée mobile dans une direction verticale par rapport au côté supérieur (42) et au côté inférieur, et dans lequel un bouton-poussoir (68) est disposé sur le côté inférieur de la plaque de pression, bouton-poussoir dont la pression permet de générer un signal de confirmation de bouton (70).

5. Procédé de commande d'un menu (50) affiché sur un élément d'affichage (48) d'un véhicule (2) selon l'une des revendications précédentes, comprenant :
- la réception d'un signal de position (62) dépendant de la position d'un doigt du conducteur sur le plateau d'impression (40),
- la mise en évidence de l'élément de menu (52) associé au segment détectable haptiquement (44) qui se trouve à la position du doigt, et
- déclenchement d'une fonction associée à l'élément de menu mis en évidence (52) lorsque la plaque de pression (40) est actionnée.

6. Dispositif de commande (60) agencé pour mettre en œuvre un procédé selon la revendication 5.

7. Programme d'ordinateur comprenant des moyens de code de programme pour exécuter toutes les étapes d'un procédé selon la revendication 5 lorsque le programme d'ordinateur est exécuté sur le dispositif de commande selon la revendication 6.
